# EUROPÄISCHE PATENTSCHRIFT

(11) **EP 2 994 671 B1**
(45) Veröffentlichungstag und Bekanntmachung des Hinweises auf die Patenterteilung: **18.04.2018**
(21) Anmeldenummer: 14725402.3
(22) Anmeldetag: 09.05.2014
(51) Int. Cl.: F16J 9/26, F16J 10/04

(54) **LAUFSATZ, KOLBENBUCHSE UND MOTORBLOCK**
RUNNING SET, PISTON BUSHING, AND ENGINE BLOCK
ENSEMBLE DE ROULEMENT, CHEMISE DE PISTON ET BLOC MOTEUR

(30) Priorität: 09.05.2013 BR 102013011586
(43) Veröffentlichungstag der Anmeldung: 16.03.2016
(73) Patentinhaber: Mahle Metal Leve S/A, 13210-877 Jundiaí, SP (BR); Mahle International GmbH, 70376 Stuttgart (DE)
(72) Erfinder: MEIRELLES TOMANIK, Antonio, Eduardo, 04618-003 Sao Paulo SP (BR)
(74) Vertreter: BRP Renaud & Partner mbB Rechtsanwälte Patentanwälte Steuerberater
(86) Internationale Anmeldenummer: PCT/EP2014/059560
(87) Internationale Veröffentlichungsnummer: WO 2014/180985

(56) Entgegenhaltungen:
- EP-A1- 2 518 373
- DE-A1-102007 008 604
- US-B2- 7 543 557
- DIMKOVSKI Z ET AL: "Quantification of the cold worked material inside the deep honing grooves on cylinder liner surfaces and its effect on wear", WEAR, ELSEVIER SEQUOIA, LAUSANNE, CH, vol. 267, no. 12, 1 December 2009 (2009-12-01), pages 2235-2242, XP026751081, ISSN: 0043-1648, DOI: 10.1016/J.WEAR.2009.06.008 [retrieved on 2009-06-16]

## Beschreibung

Die vorliegende Erfindung bezieht sich auf einen Laufsatz bestehend aus wenigstens einem Kolbenring und wenigstens einer Zylinderbuchse oder einem Zylinder als Bestandteil eines Motorblocks (integrierter Zylinder), wobei wenigstens ein Teil der durch die Buchse oder den Zylinder definierten Lauffläche einen unter 3% liegenden Anteil an gebogenem Metall aufweist.

### Beschreibung des Stands der Technik

Während der Endphase der Herstellung der Zylinderbuchse oder des in den Block eines Verbrennungsmotors integrierten Zylinders wird die innere Lauffläche dem sogenannten Honen oder Brünieren unterzogen, und zwar mit dem Ziel, solche Eigenschaften wie den angemessenen Rauheitskoeffizienten zu erwerben und so eine korrekte Funktion im Verlauf vieler Betriebsstunden mit hoher Leistung und einem niedrigen Verbrennungswert des Schmieröls zu ermöglichen.

Während des Honens oder des Brünierens fällt an der behandelten Fläche eine bestimmte Menge an gebogenem Metall (*folded metal*) an, was nachteilig ist, denn es kann zum Absplittern (*spalling*) der auf die äußere Lauffläche des Kolbenrings aufgebrachten Beschichtung führen, insbesondere wenn es sich um eine mit Hilfe des PVD-Verfahrens (*physical vapour deposition*) aufgebrachte Keramikbeschichtung handelt. Wenn die Absplitterungen der Beschichtung eine bestimmte Proportion erreichen, führt dies zur Verringerung der Lebensdauer des Verbrennungsmotors, denn der Ring beginnt, sein Trägermaterial zu verschleißen, was auch zur Beschädigung der Brennraumabdichtung führt.

Eine Lösung zur Erhöhung der Haltbarkeit der Beschichtungen auf Motorkomponenten (Motorblock oder Buchsen, fest oder demontierbar), versehen mit wenigstens einem Zylinder und im Wesentlichen aus Eisen bestehend, wird im Dokument PI 1100176-3 des gleichen Anmelders angegeben, in dem die Komponenten mit einer Beschichtung versehen werden, die in drei verschiedene auf einem Metallsubstrat aufgebrachte Schichten unterteilt ist, wobei eine erste Schicht aus reinem auf dem Substrat aufgebrachten Silizium besteht, das die Funktion hat, eine Schnittstelle mit guter Haftung zwischen dem Metallsubstrat und den folgenden amorphen Kohlenstoff enthaltenden Schichten zu bilden, eine Übergangsschicht Anteile von Silizium und amorphem Kohlenstoff (a-C:H:Si) enthält, und schließlich an der Arbeitsfläche eine zweite Schicht aus einer reinen Zusammensetzung von amorphem Kohlenstoff (a-C:H) besteht, wobei diese Beschichtung über den Hohlkathodeneffekt (HCE) mittels plasmagestützter chemischer Dampfabscheidung (PECVD) hergestellt wird.

Eine Alternative besteht darin, Zylinderbuchsen/Zylinder mit einer Thermospray-Beschichtung zu verwenden, aber diese Art der Beschichtung erfordert sehr viel höhere Umsetzungskosten, auch auf Grund der größeren Schichtdicke des verwendeten Materials. Hinzu kommt, dass diese Art der Beschichtung nicht ohne eine Studie auskommt, die auch die Beschichtungsart der Kolbenringe im Hinblick auf die Maximierung der Ergebnisse hinsichtlich der Haltbarkeit einbezieht.

Die US 7,543,557 B2 zeigt einen Verbrennungsmotor mit einem Zylinder, in dem ein Kolben hubverstellbar angeordnet ist. Der Zylinder weist eine Zylinderlauffläche auf, die mit einer Lauffläche eines Rings des Kolbens zusammenwirkt. Die Zylinderlauffläche wird während der Herstellung gebürstet und anschließend derart feingeschliffen, dass beim Bürsten entstehende Metallreste entfernt werden.

Das deutsche Patentdokument DE 102007008604 betrifft ein Verfahren zur Bewertung von Honstrukturen, wie die Lauffläche einer Buchse/eines Zylinders, was die Quantifizierung des Anteils an gebogenem Metall ermöglicht, wobei der bestehende Anteil untersucht und mit dem Absplittern der Beschichtung an den Kolbenringen in Beziehung gesetzt werden kann, sowie auch andere Eigenschaften, die man zu untersuchen wünscht und die hiermit in Zusammenhang stehen.

Das deutsche Patentdokument DE 10302055 betrifft ein Weißlichtinterferometer, das es ermöglicht, unter dem Einfluss eines optischen oder magnetisches Feldes, die Tiefenabtastung eines Objekts vorzunehmen, so dass das Vorhandensein und die Anteile an gebogenem Metall an der inneren Lauffläche einer Buchse/eines Zylinders festgestellt werden können.

Schließlich betrifft das deutsche Patentdokument DE 102005023212 ein Verfahren zur Steigerung der Messgeschwindigkeit und Messgenauigkeit, das eine genauere Messung der Objekte ermöglicht.

Das Vorhandensein dieser Art von Messtechnologien ermöglichte es dem Anmelder, die prozentuale Quantifizierung des Anteils an gebogenem Metall in brünierten Strukturen sehr genau zu untersuchen, wobei der vorhandene Anteil untersucht und mit dem Absplittern der Beschichtung an den Kolbenringen in Beziehung gesetzt werden konnte, sowie auch andere Eigenschaften, die er zu untersuchen wünschte und die hiermit im Zusammenhang stehen, und zwar mit Hilfe von Parametern in Verbindung mit der Produktentwicklung, wie Leistung, Haltbarkeit und Kosten.

### Aufgabe der Erfindung

Im Wesentlichen beschrieben liegt der vorliegenden Erfindung die Aufgabe zugrunde, eine Kombination zwischen einem Kolbenring, dessen äußere Lauffläche mit einer mit Hilfe des PVD-Verfahrens (*physical vapour deposition*) aufgebrachten Beschichtung versehen ist, und einer inneren Lauffläche einer Buchse oder eines Zylinders mit einem geringen Anteil an gebogenem Metall zu schaffen.

Genauer gesagt liegt der vorliegenden Erfindung die Aufgabe zugrunde, einen Laufsatz bestehend aus wenigstens einem Kolbenring und wenigstens einer Zylinderbuchse oder einem Zylinder als Bestandteil eines Motorblocks (integrierter Zylinder) zu schaffen, bei dem wenigstens ein Teil der durch die Buchse oder den Zylinder definierten Lauffläche eine Keramikbeschichtung besitzt und wenigstens ein Teil der inneren Lauffläche der Buchse/des Zylinders einen unter 3% liegenden Anteil an gebogenem Metall aufweist.

Schließlich liegt der vorliegenden Erfindung die Aufgabe zugrunde, einen Motorblock mit wenigstens einem integrierten Zylinder zu schaffen, bei dem wenigstens ein Teil der durch den Ring definierten Lauffläche eine Keramikbeschichtung besitzt und wenigstens ein Teil der inneren Lauffläche der Buchse/des Zylinders einen unter 3% liegenden Anteil an gebogenem Metall aufweist.

### Kurze Beschreibung der Erfindung

Die Aufgaben der vorliegenden Erfindung werden durch einen Laufsatz zur Verwendung in einem Verbrennungsmotor gelöst, umfassend wenigstens eine Zylinderbuchse oder einen Motorblock mit wenigstens einem integrierten Zylinder und wenigstens einen Kolbenring, wobei der Ring eine äußere Lauffläche definiert und die Buchse/der integrierte Zylinder eine innere Lauffläche definiert, die äußere Lauffläche des Rings gleitend mit der inneren Lauffläche der Buchse/des integrierten Zylinders zusammenwirkt, wobei wenigstens ein Teil der äußeren Lauffläche des Rings eine aus Keramikmaterial bestehende Beschichtung aufweist und wenigstens ein Teil der inneren Lauffläche der Buchse/des integrierten Zylinders einen unter 3% liegenden Anteil an gebogenem Metall aufweist. Weiter werden die Aufgaben der vorliegenden Erfindung durch einen Verbrennungsmotor mit einem solchen Laufsatz gelöst.

### Kurze Beschreibung der Zeichnungen

Die Erfindung wird nachfolgend an Hand von Ausführungsbeispielen unter Bezugnahme auf die Zeichnungen näher beschrieben. Diese zeigen:
Figur 1 - eine schematische Ansicht des Laufsatzes, der den Gegenstand der Erfindung bildet.
Figur 2 - eine Grafik zum Vergleich der Leistung des Laufsatzes, der den Gegenstand der Erfindung bildet, im Vergleich zu einem gegenwärtig bekannten Laufsatz.
Figur 3 - eine vergrößerte Ansicht des oberen Abschnitts der Kontaktfläche eines Rings der ersten Nut nach Betrieb in einer Buchse/einem Zylinder, dessen innere Lauffläche einen normalen Anteil, Standardanteil oder kontrollierten Anteil an gebogenem Metall aufweist.
Figur 4 - eine vergrößerte Ansicht des mittleren Abschnitts der Kontaktfläche eines Rings der ersten Nut nach Betrieb in einer Buchse/einem Zylinder, dessen innere Lauffläche einen normalen Anteil, Standardanteil oder kontrollierten Anteil an gebogenem Metall aufweist.
Figur 5 - eine vergrößerte Ansicht des oberen Abschnitts der Kontaktfläche eines Rings der ersten Nut nach Betrieb in einer Buchse/einem Zylinder, dessen innere Lauffläche einen unter 3% liegenden Anteil an gebogenem Metall aufweist (vorliegende Erfindung).
Figur 6 - eine vergrößerte Ansicht des mittleren Abschnitts der Kontaktfläche eines Rings der ersten Nut nach Betrieb in einer Buchse/einem Zylinder, dessen innere Lauffläche einen unter 3% liegenden Anteil an gebogenem Metall aufweist (vorliegende Erfindung).
Figur 7 - eine Tabelle, die die Absplitterung am Kolbenring mit PVD-Beschichtung illustriert, und zwar (i) beim Betrieb in einer Buchse/einem Zylinder, dessen innere Lauffläche einen hohen Anteil an gebogenem Metall aufweist und (ii) beim Betrieb in einer Buchse/einem Zylinder, dessen innere Lauffläche einen unter 3% liegenden Anteil an gebogenem Metall aufweist (vorliegende Erfindung).

### Detaillierte Beschreibung der Figuren

Die vorliegende Erfindung betrifft im Wesentlichen die Kombination, in einem Laufsatz zur Verwendung in einem Verbrennungsmotor, von einem Kolbenring, dessen äußere Lauffläche mit einer mit Hilfe des PVD-Verfahrens (*physical vapour deposition*) aufgebrachten Keramikbeschichtung versehen ist, und einer inneren Lauffläche einer Buchse oder eines Zylinders mit einem geringen Anteil an gebogenem Metall.

Der Laufsatz umfasst im Wesentlichen eine Zylinderbuchse 4 oder einen Motorblock mit wenigstens einem integrierten Zylinder 4' und wenigstens einen Kolbenring 2. Der Ring 2 definiert eine äußere Lauffläche 3, und die Buchse/der integrierte Zylinder 4,4' definiert eine innere Lauffläche 5, die äußere Lauffläche 3 des Rings 2 wirkt gleitend mit der inneren Lauffläche 5 der Buchse/des integrierten Zylinders 4,4' zusammen.

Auf jeden Fall bildet der Ring der ersten Nut nicht die Hauptaufgabe der vorliegenden Erfindung, seine Form und seine Zusammensetzung können frei variiert werden, solange seine äußere Lauffläche 3 mit einer Keramikbeschichtung versehen ist, die mit Hilfe der physikalischen Dampfabscheidung (*physical vapour deposition* - *PVD*) aufgebracht wurde.

Obwohl die Beschichtung theoretisch frei variiert werden kann, weist eine durch das PVD-Verfahren aufgebrachte Keramikbeschichtung eine Reihe von Eigenschaften auf, die für viele Anwendungen Vorteile mit sich bringt im Vergleich zu anderen Arten von Beschichtungen oder Oberflächenbehandlungen und/oder anderen Aufbringungsverfahren. Allerdings ist sie auch am empfindlichsten im Hinblick auf Absplitterungen (*spalling*)*.*

Genauer gesagt ist die auf den Ring 2 aufgebrachte Keramikbeschichtung eine Beschichtung aus Chromnitrid (CrN); die Zusammensetzung dieses Keramikmaterials kann jedoch variieren, ohne dass die Erfindung aus dem Schutzbereich der Patentansprüche herausfallen würde. Als Alternative kann eine Beschichtung aus Chromnitrid (Cr₂N), Niobnitrid (NbN) oder auch einer anderen notwendigen oder wünschenswerten Keramik verwendet werden.

Was die Zylinderbuchse 4 oder den im Motorblock 4' integrierten Zylinder betrifft, können beide Laufflächen 5 verschiedene Beschaffenheiten aufweisen, ohne dass sie aus dem Schutzbereich der Patentansprüche herausfallen würden. Wie oben bereits erwähnt, wird die innere Lauffläche 5 während des Herstellungsverfahrens des Teils dem Honen oder Brünieren unterzogen, so dass seine effiziente Funktion für viele Betriebsstunden mit hoher Leistung und einem niedrigen Verbrennungswert des Schmieröls gesichert ist.

Die in diesem Bereich tätigen Techniker wissen jedoch, dass während des Honens oder des Brünierens an der behandelten Fläche eine bestimmte Menge an gebogenem Metall (*folded metal*) anfällt, was zum Absplittern (*spalling*) der auf die äußere Gleitfläche des Kolbenrings aufgebrachten Beschichtung führt, insbesondere wenn es sich um eine mit Hilfe des PVD-Verfahrens (*physical vapour deposition*) aufgebrachte Keramikbeschichtung handelt.

Wenn die Absplitterungen der Beschichtung eine bestimmte Proportion erreichen, führt dies zur Verringerung der Lebensdauer des Verbrennungsmotors, denn der Ring beginnt, sein Trägermaterial zu verschleißen, was auch zur Beschädigung der Brennraumabdichtung führt.

Bis zum gegenwärtigen Zeitpunkt wurden noch keine gründlichen Untersuchungen über den Zusammenhang zwischen dem Anteil an gebogenem Metall und der Absplitterung der Beschichtungen an den Ringen durchgeführt, ebenso wenig gibt es Untersuchungen darüber, ob die Entfernung des größten Teils dieses gebogenen Metalls durchführbar ist und ob dies zur Steigerung der Haltbarkeit der Ringe führen würde.

Der von den Lieferanten der Motorkomponenten beschrittene Weg führte bisher zur Verbesserung der mit dem PVD-Verfahren aufgebrachten Keramikschichten und Alternativlösungen, damit die Leistung des Motors längere Zeit auf dem gleichen Niveau gehalten werden konnte.

Mit der vorliegenden Untersuchung und Erfindung hat der Anmelder das Paradigma für den Umgang mit dieser Art von Absplitterungen komplett verändert, was ein hohes Maß an Innovation bei seiner Forschung und die Originalität der erzielten Ergebnisse zeigt, denn diese waren noch nie wissenschaftlich untersucht worden und daher unvorhersehbar oder unerwartet.

Nach Durchführung verschiedener Prüfungen und Tests fand der Anmelder heraus, dass die anteilsmäßige Verringerung an gebogenem Metall an der inneren Lauffläche 5 eine Verringerung der Absplitterung der auf die äußere Lauffläche 3 des Rings aufgebrachten Beschichtung nach sich zieht, insbesondere bei den üblicherweise verwendeten mit PVD aufgebrachten Keramikbeschichtungen.

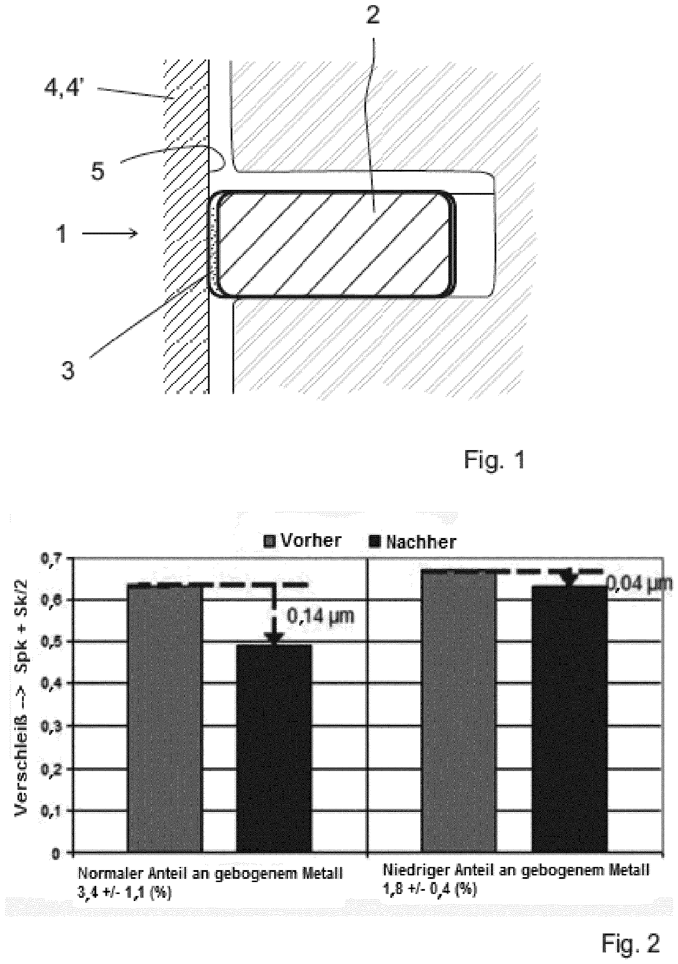

Figur 2 stellt eine zusammengesetzte Grafik dar, die eine Vergleichsprüfung illustriert. Der linke Teil der Grafik zeigt die Ergebnisse der Prüfung eines Kolbenrings mit einer Keramikbeschichtung aus CrN, aufgebracht mit PVD, in einer Buchse/einem Zylinder, dessen Innenfläche 5 wenigstens teilweise einen Anteil an gebogenem Metall von 4,4% (+/- 1,1%) aufweist, wobei dieser Wert als Normal-, Standard- oder Kontrollwert angesehen wird. Nach der Prüfung wurde festgestellt, dass der Verschleiß der Beschichtung bei 0,14 µm lag.

Der rechte Teil der Grafik zeigt die Ergebnisse der Prüfung eines identischen Rings, unter den gleichen Bedingungen, nur dass in diesem Fall die Innenfläche 5 der Buchse/des Zylinders wenigstens teilweise einen Anteil an gebogenem Metall von 1,8% (+/- 0,4%) aufweist, wobei dieser Wert als niedrig angesehen wird. Nach der Prüfung wurde festgestellt, dass der Verschleiß der Beschichtung bei 0,04 µm lag.

Da die sonstigen Variablen bei beiden Prüfungen die gleichen waren, ist die starke Verringerung des Verschleißes (0,04 µm im Vergleich zu 0,14 µm, weniger als ein Drittel) klar ersichtlich.

Dieser Test war einer von unzähligen Tests, die durchgeführt wurden und er ist weitgehend repräsentativ bei der Feststellung, dass die Verringerung des Verschleißes der Ringbeschichtung wesentlich ist, wenn der Anteil an gebogenem Metall von etwa 4% auf 2% fällt.

So kam der Anmelder, nachdem er eine Reihe von Simulationen und Tests durchgeführt hatte, zu dem Schluss, dass die besten Eigenschaften erzielt werden, wenn wenigstens ein Teil der inneren Lauffläche 5 der Buchse/des integrierten Zylinders 4,4' einen unter 3% liegenden Anteil an gebogenem Metall aufweist.

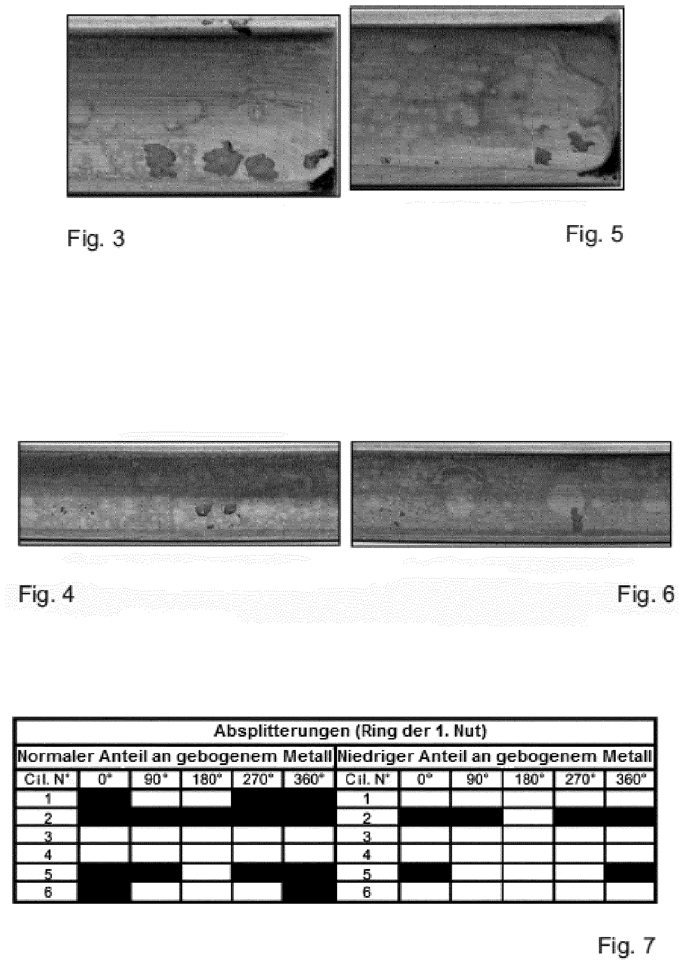

Der Vergleich zwischen den Figuren 3 und 5 zeigt sehr deutlich die erhebliche Verringerung der Absplitterungen (unregelmäßige dunklere Hohlräume, die "abgerissene" Stücke der Beschichtung darstellen), als der Ring in einer Buchse/einem integrierten Zylinder 4,4' mit einem Anteil von 1,8% gebogenem Metall (Figur 5) geprüft wurde, im Vergleich zu einem identischen Ring, dieser jedoch geprüft in einer Buchse/einem integrierten Zylinder 4,4' mit einem Anteil von 4,4% an gebogenem Metall (Figur 3).

Analog dazu zeigt eine vergleichende Analyse der Figuren 4 und 6 die gleiche Verringerung der Absplitterungen, hier jedoch im mittleren Abschnitt der Kontaktfläche eines Rings und nicht in seinem oberen Abschnitt, wo die Beanspruchungen kritischerer Natur sind.

Schließlich illustriert die Tabelle in Figur 7 einen Vergleich zwischen den Absplitterungen der geprüften Ringe in einem 6-Zylinder-Verbrennungsmotor, jedoch unter dem Gesichtspunkt der Anordnung dieser Absplitterungen verteilt über das 360°-Format des Rings.

Als der Ring in Bezug auf eine Fläche 5 mit einem als Normal- oder Kontrollwert angesehenen Anteil an gebogenem Metall getestet wurde, wurden Absplitterungen an den Ringen von vier der sechs Zylinder festgestellt. Als der Test mit dem gleichen Motor und unter gleichen Bedingungen wiederholt wurde, mit Ausnahme des Anteils an gebogenem Metall (hier niedriger), wurden Absplitterungen an nur zwei Ringen festgestellt, und der Verschleiß war wesentlich geringer.

Zum Schluss ist noch hervorzuheben, dass die vorliegende Erfindung auch getrennt voneinander eine Zylinderbuchse 4 und einen Motorblock umfasst.

Die Zylinderbuchse 4, die den Gegenstand der vorliegenden Erfindung bildet, wird dadurch gekennzeichnet, dass sie eine innere Lauffläche 5 definiert, bei der wenigstens ein Teil einen unter 3% liegenden Anteil an gebogenem Metall aufweist.

Der Motorblock, der den Gegenstand der vorliegenden Erfindung bildet und mit wenigstens einem integrierten Zylinder 4' versehen ist, wird ebenfalls dadurch gekennzeichnet, dass der Zylinder 4' eine innere Lauffläche 5 definiert, bei der wenigstens ein Teil einen unter 3% liegenden Anteil an gebogenem Metall aufweist.

Ungeachtet der Beschreibung eines bevorzugten Ausführungsbeispiels erfasst der Geltungsbereich der vorliegenden Erfindung andere mögliche Variationen, die nur durch den Inhalt der verbundenen Patentansprüche begrenzt werden, mögliche gleichwertige eingeschlossen.

## Patentansprüche

1. Laufsatz zur Verwendung in einem Verbrennungsmotor, umfassend wenigstens eine Zylinderbuchse (4) oder einen Motorblock mit wenigstens einem integrierten Zylinder (4') und wenigstens einem Kolbenring (2), wobei der Ring (2) eine äußere Lauffläche (3) definiert und die Buchse/der integrierte Zylinder (4,4') eine innere Lauffläche (5) definiert, die äußere Lauffläche (3) des Rings (2) gleitend mit der inneren Lauffläche (5) der Buchse/des integrierten Zylinders (4,4') zusammenwirkt; der Laufsatz wird **dadurch gekennzeichnet, dass** wenigstens ein Teil der äußeren Lauffläche (3) des Rings (2) eine aus Keramikmaterial bestehende Beschichtung aufweist und wenigstens ein Teil der inneren Lauffläche (5) der Buchse/des integrierten Zylinders (4,4') einen unter 3% liegenden Anteil an gebogenem Metall aufweist.

2. Laufsatz nach Anspruch 1, **dadurch gekennzeichnet, dass** die auf wenigstens einen Teil der äußeren Lauffläche (3) des Rings (2) aufgebrachte Keramikbeschichtung aus Chromnitrid (CrN) besteht, aufgebracht mit Hilfe der physikalischen Dampfabscheidung (*physical vapour deposition* - *PVD*)*.*

3. Verbrennungsmotor mit einem Laufsatz nach Anspruch 1 oder 2.

## Claims

1. Running set for use in an internal combustion engine, comprising at least one cylinder liner (4) or an engine block with at least one integrated cylinder (4') and at least one piston ring (2), wherein the ring (2) defines an outer running face (3) and the liner/the integrated cylinder (4, 4') defines an inner running face (5), the outer running face (3) of the ring (2) interacting slidingly with the inner running face (5) of the liner/the integrated cylinder (4, 4'); the running face is **characterised in that** at least one part of the outer running face (3) of the ring (2) comprises a coating composed of a ceramic material and at least one part of the inner running face (5) of the liner/the integrated cylinder (4, 4') comprises a proportion of less than 3% of a folded metal.

2. Running set according to claim 1, **characterised in that** the ceramic coating disposed on at least one part of the outer running face (3) of the ring (2) consists of chromium nitride (CrN), applied via physical vapor deposition (PVD).

3. Internal combustion engine with a running set according to claim 1 or 2.

## Revendications

1. Ensemble de roulement pour utilisation dans un moteur à combustion interne, comprenant au moins une chemise de cylindre (4) ou un bloc moteur avec au moins un cylindre intégré (4') et au moins un segment de piston (2), dans lequel le segment (2) définit une surface de roulement externe (3) et la chemise ou le cylindre intégré (4, 4') définit une surface de roulement interne (5), la surface de roulement externe (3) du segment (2) coopère à coulissement avec la surface de roulement interne (5) de la chemise ou du cylindre intégré (4, 4') ; l'ensemble de roulement étant **caractérisé en ce qu'**au moins une partie de la surface de roulement externe (3) du segment (2) présente un revêtement constitué d'un matériau de céramique et au moins une partie de la surface de roulement interne (5) de la chemise ou du cylindre intégré (4, 4') présente une fraction de métal cintré se situant en dessous de 3 %.

2. Ensemble de roulement selon la revendication 1, **caractérisé en ce que** le revêtement de céramique appliqué sur au moins une partie de la surface de roulement externe (3) du segment (2) est constitué de nitrure de chrome (CrN), appliqué par dépôt en phase vapeur par un procédé physique (*physical vapour deposition* - PVD).

3. Moteur à combustion interne pourvu d'un ensemble de roulement selon la revendication 1 ou 2.
